# EUROPEAN PATENT APPLICATION

(11) **EP 4 712 330 A1**
(43) Date of publication of application: **18.03.2026**
(21) Application number: 25188752.7
(22) Date of filing: 10.07.2025
(51) Int. Cl.: H02M 3/157, H02M 3/158, H02M 1/00, G01R 19/175

(54) **VOLTAGE REGULATOR WITH SOFT-SWITCH CONTROL**

(30) Priority: 17.09.2024 US 202418887414
(71) Applicant: INTEL Corporation, Santa Clara, CA 95054 (US)
(72) Inventor: DEKA, Anupjyoti, 560103 Bangalore (IN); TYAGI, Shobhit, Bangalore (IN)
(74) Representative: Viering, Jentschura & Partner mbB Patent- und Rechtsanwälte

(57) **Abstract**

Disclosed are voltage regulator embodiments with dynamically adjustable soft-switching entry (e.g., ZCD) thresholds to efficiently manage entry into soft-switching under different load conditions.

## Description

### TECHNICAL FIELD

Embodiments relate to the field of integrated circuits, and more specifically, to the field of voltage regulators.

### BRIEF DESCRIPTION OF THE DRAWINGS

The disclosure may best be understood by referring to the following description and accompanying drawings that are used to illustrate embodiments of the invention. In the drawings:
Fig. 1 is a schematic diagram of a conventional switching type DC-DC voltage regulator.
Fig. 2 illustrates timing diagrams for high and low side switching of the regulator of Fig. 1.
Figs. 3A and 3B are diagrams illustrating V*I losses for a switching regulator with and without soft-switching being employed.
Fig. 4 is a schematic diagram showing a voltage regulator with dynamically adjustable soft-switch entry in accordance with some embodiments.
Fig. 5 is a flow diagram showing a routine for controlling soft-switch entry for the circuit of Fig. 4 in accordance with some embodiments.
Fig. 6A is a timing diagram showing relevant signals for the regulator of Fig. 4 for high side power switch (HS) switching using soft-switching in accordance with some embodiments.
Fig. 6B shows a series of timing diagrams illustrating how the routine of Fig. 5 may operate to adjust a negative inductor current threshold in accordance with some embodiments.
Fig. 7 is a schematic diagram showing a voltage regulator circuit with a dynamic zero cross detector (ZCD) threshold in accordance with some additional embodiments.
Fig. 8 is a schematic diagram showing an implementation of the circuit of Fig. 7 in accordance with some embodiments.
Fig. 9 is a flow diagram showing a routine for managing soft-switching entry in accordance with some embodiments of the regulator of Fig. 8.
Fig. 10 is a schematic diagram showing an integrated circuit (IC) package in accordance with some embodiments.
Fig. 11 illustrates an example computing system in accordance with some embodiments.

### DETAILED DESCRIPTION

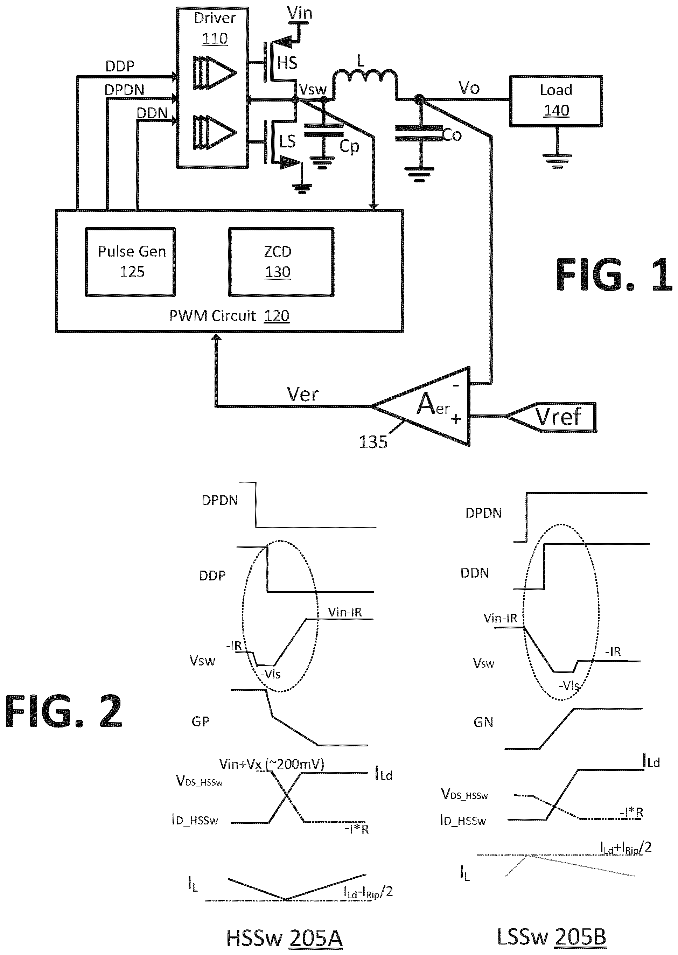

Fig. 1 is a schematic diagram of a conventional switching type DC-DC converter, also referred to as a switching DC-DC voltage regulator. There are different types of switching regulators including buck types for stepping down a DC voltage, boost types for stepping up a DC voltage, and buck-boost types for doing either or both stepping down and stepping up a DC voltage. With this disclosure, a buck type regulator is used to present the concepts disclosed herein but it should be appreciated that they may be employed in other switching DC-DC converter types as well.

The depicted voltage regulator example includes a high side power switch (HS), a low side power switch (LS), and an inductor (L) coupled as shown at an inductor switch node (Vsw). It also includes a capacitor (Co), a driver circuit 110, a pulse width modulator (PWM) circuit 120, and feedback amplifier 135, coupled as shown to provide the output voltage supply (Vo) to a load 140. Also depicted is the parasitic capacitance (Cp) that is typically present at the inductor input switching node (Vsw).

The high and low side power switches are typically implemented with transistors such as P and/or N type metal oxide semiconductor field effect transistors (MOSFETs), although the low-side switch may be implemented with a diode in some designs. With this example, the high side switch (HSsw) uses a P-type MOS transistor, and the low side switch (LSsw) uses an N-type MOS transistor. (There are also some designs that group together transistors, in parallel, series, or both, to form the high and/or low side switches. Similarly, while it is easier to control switching for designs, as shown, with a high side P-type switch and a low-side N type switch, some designs may use N-type or P-type devices for either or both power switches.)

The power switches are controlled by the PWM circuit 120 through the driver circuit 110 to regulate the output voltage (Vo) at a level that corresponds to Vref. The PWM (pulse width modulator) circuit generates the control signals that dictate the switching frequency and duty cycle for the power switches. It compares the output voltage (Vo) with the reference voltage (Vref) and adjusts the duty cycle of the HS power switch accordingly to maintain the desired output voltage.

The inductor and capacitor form a low-pass filter to smooth the output voltage. Buck operation is based on the principle of storing energy in the inductor. When the HS switch is on, the inductor stores energy by allowing current (I_{L}) to flow through it and on into the load and capacitor. Conversely, when the high switch is off, the inductor releases its stored energy to the load and output capacitor.

The driver circuit 110 is responsible for providing the necessary voltage and current to turn the power switches on and off quickly. Ideally, it facilitates efficient switching and minimizes transition losses. The depicted driver 110 has circuitry to facilitate individually controllable dead times between high and low side switch activations. There is a common pulse train signal (DPDN) that is used for turning on each of the high and low side switches. Each switch also has an associated delay activation signal (DDP, DDN) for the HS and LS switches, respectively. The HS switch is turned on when the DPDN and DDP signals are both low, while the LS switch is turned on when the DPDN and DDN signals are both high. This is illustrated in the timing diagrams of Fig. 2 where high side switching is shown at 205A, and low side switching is shown at 205B.

In some implementations, the driver circuit may also be coupled to nodes such as Vsw in the power switch stack to control the switches to operate at certain bias scenarios depending on operating conditions. Moreover, the driver circuit may be integrated into the PWM circuit 120 or implemented as separate components.

The PWM circuit 120 essentially controls the ratio of on-time to off-time (duty cycle) of the HS switch to regulate the output voltage to a desired value. The feedback amplifier 135 provides it with an amplified error signal (Ver) reflecting a difference between the reference voltage and the output (Vo) for closed loop voltage control through modulation of the pulse signal generated by the PWM 120. In this way, it causes the PWM to control drive circuit 110 to switch the high and low side switches with the pulse train signal (DPDN) to regulate the output voltage (Vo) at the desired reference voltage (Vref) level.

Among other things, the PWM circuit 120 includes a pulse generator circuit 125 and a zero cross detector (ZCD) circuit 130. The pulse generator 125 generates the pulse signal (DPDN) with a controllable duty cycle, while the ZCD circuit 130 is used to monitor inductor current for a variety of purposes including controlling the regulator's operational modes such as whether it is in a soft or hard switching mode and whether it is in a discontinuous or continuous current mode.

Integrated voltage regulators typically employ soft-switching mechanisms to operate at lower load currents for efficiency benefits. For voltage regulators operating at low currents, losses are generally dominated by switching losses. They arise from energy losses while turning on and off the power FETs, which are usually heavily sized, resulting in considerable capacitances having to be charged and discharged with every switching cycle. In addition, there are "IR" losses attributable to high side drain/source power drops (V_{DS} * I_{D}) during turn-on and turn-off.

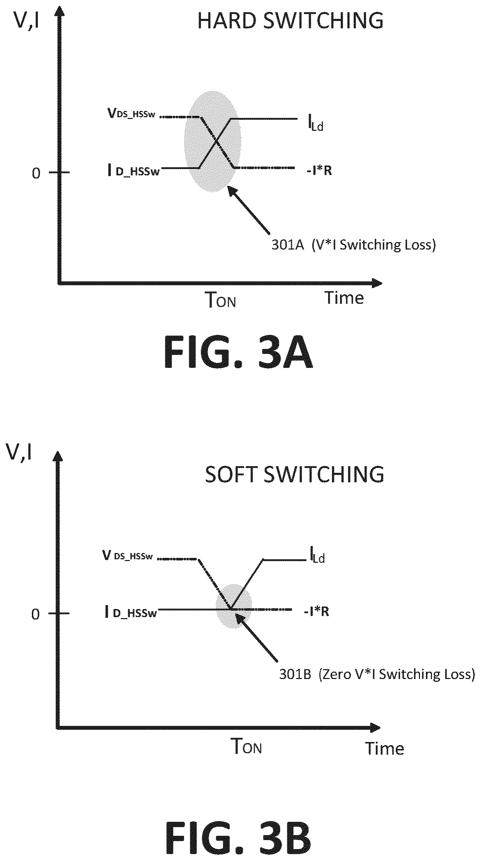

Soft-switching serves to reduce the V*I losses by causing the FET(s) to switch on and/or off when either current or voltage across the FET is near, or at, 0 to achieve significantly lower V*I losses. This is illustrated in Figs. 3A and 3B, which shows V*I losses for hard switching (301A) and soft-switching (301B).

With reference to Fig. 2, when the regulator transitions from low to high or high to low, a dead time where both switches (FETs) are off is introduced to avoid crowbar current from the input supply (Vin) to ground during the transition. As illustrated at 205B, when the pulse train signal (DPDN) transitions from low to high, the HS switch is first turned off, and during the dead time (until DDN goes High), the Vsw node falls as its parasitic capacitance provides the inductor current (I_{L}) until current can be drawn from the LS switch, which clamps Vsw to -Vₗₛ (the reverse LS diode drop or V*I drop across the LS switch if kept slightly on to prevent reverse source/drain conduction). Thus, by the time the LS Switch is actively turned on (when DDN goes High), the Vsw has already fallen (V_{DS} across LS switch is ~0V), resulting in an inherent soft-switching for the LS switch.

However, when the pulse train signal (DPDN) transitions from High to Low (LS switch turns off), for high loads, the VSW node again falls as its parasitic capacitance provides the inductor current. When DDP goes low and the HS switch turns on, it has to pull up the Vsw from -Vls (drop across HS switch is Vin + Vₗₛ), resulting in V_{DS}*I_{D} losses for the HS switch. But since the load current is high, it will not sufficiently discharge the inductor and cause its current to reverse. That is, the dead time required for a reverse inductor current in this situation would be incompatible with other operational requirements of the regulator. However, it is possible to implement soft-switching for HS switching with low and intermediate loads (e.g., when the load current is less than half of the inductor ripple current) where the inductor current reverses at the end of the LS switch on-phase. In this case, the reversed inductor current can pull up the parasitic capacitance on Vsw, and the HS switch can be turned on once Vsw is pulled up sufficiently so that V_{DS} is close to 0V when it is turned on. However, as discussed below, for such soft-switching to be efficient, it should be engaged under suitable conditions, which will vary with different specific circuit parameters and dynamic load conditions.

With conventional implementations, soft-switching modes are typically activated by detecting when the inductor current falls below 0, i.e., starts reversing. To do this, zero crossing detection (ZCD) circuits such as ZCD 130 with a fixed zero crossing detector are typically used. Unfortunately, in many cases, this is not always an optimal point for soft-switching entry, resulting in efficiency reduction for a range of different load conditions.

Soft-switching may normally be beneficial for most lighter loads, but even with low inductor current that approaches or even goes beyond reversing direction, depending on specific regulator parameters, it may not be sufficient to pull up the inductor switching node and enable zero voltage switching for HS switch turn-on. Under such conditions, soft-switching modes can result in efficiency losses due to higher I²R losses across the LS switch without the benefit of reducing V*I losses. With many use cases, an optimum load point for soft-switching entry may be at lower reverse currents, depending on such factors as power switch sizing, Inductor values and transistor process characteristics.

Accordingly, in some embodiments, techniques for dynamically adjusting soft-switch (SS) entry thresholds are provided. For example, in some embodiments, a SS entry control circuit may be used to monitor an inductor switch node voltage in pre HS-on dead times (also referred to as TDP dead times) when the regulator is operating in a soft-switching mode to determine if it is operating effectively and if not, to dynamically adjust SS entry threshold such that it will occur at an effective point where inductor current has reversed and is sufficiently negative within the TDP dead time to pull up the switch node to reduce HS switch V*I losses and improve efficiency. In some embodiments, efficiency improvements of 3% or higher at lower load ranges have been observed. This can be significant, especially considering state of the art integrated circuit (IC) products such as multi-chip processor packages that can employ hundreds of integrated switching regulators across hundreds of different power and voltage domains. Moreover, in some embodiments, these solutions can be independent of specific regulator circuit configuration parameters and thus be used without special adjustments or testing across a wide array of different use cases.

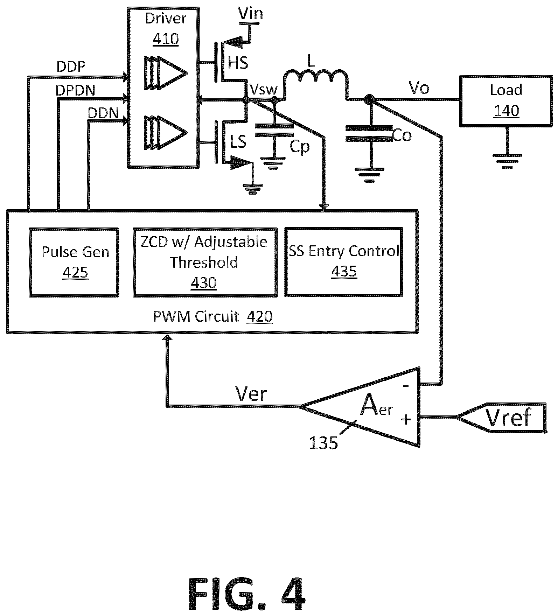

Fig. 4 is a schematic diagram showing a voltage regulator with dynamically adjustable soft-switch entry in accordance with some embodiments. This regulator circuit is similar to the circuit of Fig. 1 except that it has a driver circuit 410 and PWM circuit 420 with circuitry for implementing dynamically adjustable SS entry. The PWM 420 includes a ZCD circuit 430 with an adjustable threshold for adjusting where and/or when the regulator will enter into a soft-switch mode. The PWM also has SS entry control circuitry 435 to work in cooperation with the adjustable ZCD threshold to monitor whether the threshold is at an effective level, and if not, to adjust it accordingly.

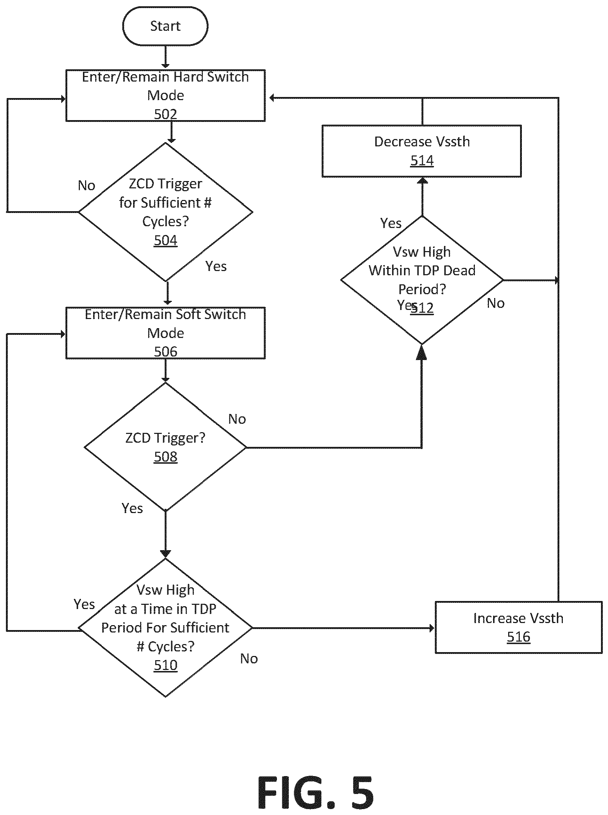

Fig. 5 is a flow diagram showing a routine for controlling SS entry for the circuit of Fig. 4 in accordance with some embodiments. At 502, the routine starts with the regulator entering, or remaining in, a hard switching mode. At 504, it checks to determine if the ZCD circuit triggered. This refers to the ZCD indicating that the inductor current went sufficiently negative at a meaningful time in the charge/discharge cycle. For example, the ZCD circuit may be checked to determine if Vsw exceeded the ZCD threshold at the end of an LS on-state phase. For example, it may be evaluated or latched off of the pulse train signal (e.g., DPDN) that turns off the LS switch to determine if the inductor current was sufficiently negative to pull the Vsw node beyond the ZCD threshold at the end of an LS on-state phase. It is not critical that the ZCD is checked at this exact transition time, but in some embodiments, it may provide a convenient place to evaluate the inductor current. In many implementations, this pulse train LS turn-off transition may be an appropriate place and serve as a convenient signal for assessing if the inductor current is sufficiently negative to warrant entry into soft-switching (SS) mode. In some embodiments, a condition that this triggering occurs in a minimum number of consecutive cycles may be used to improve control stability, although any number (e.g., 1, 2, 3, or more) of cycles may be used depending on particular design objectives.

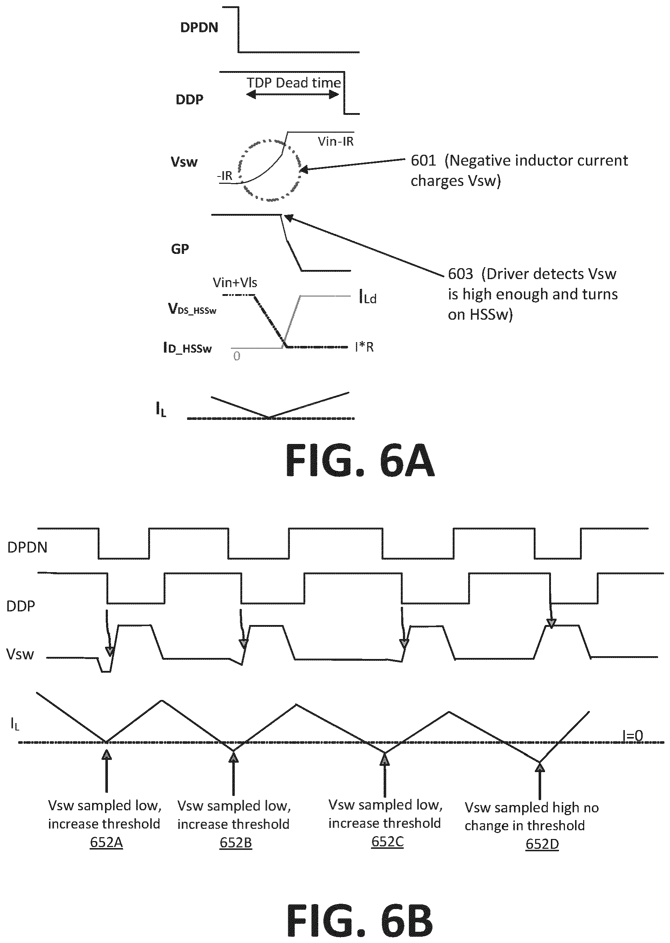

If the ZCD does not trigger for the required number of cycles, the routine loops back to 502 and remains in hard switching mode. On the other hand, if the ZCD triggers, then the routine proceeds to 506 and causes the regulator to enter into soft-switch mode. From here, it proceeds to 508 and determines if, e.g., confirms, that the ZCD circuit is triggering, as described above, e.g., at the end of the LS on-time phase. If it is triggering, then the routine proceeds to 510 and determines if the Vsw is high at a time within the TDP transition period. The TDP dead time is the time period between the LS switch turning off and the HS switch turning on. This is illustrated in the timing diagram of Fig. 6A, which shows relevant signals for the regulator of Fig. 4 for the HS switch being switched on through soft-switching. As can be seen, during the TDP period, the Vsw is charged (at 601) by the negative inductor current. When it is high enough, e.g., as detected by the driver (at 603), the driver turns the HS switch on with the PFET gate node, GP, going low.

In some embodiments, this Vsw high confirmation may be required for a predefined number of consecutive cycles to satisfy the 510 determination. In addition, in some embodiments, a different detection circuit, e.g., a SS evaluation circuit apart from the ZCD, may be used to make this High state determination. It may be done by a ZCD circuit or alternatively, it may be done by a different and/or separate circuit, and it may be taken at the Vsw node, itself, or at another node within the HS/LS switch stack. For example, a comparator may be used or in some embodiments, as described below, a digital gate or sequential circuit may be used to evaluate whether the monitored node is above a defined or inherent threshold. Since in many implementations, the SS mode may have a HS override, just because the HS switch is turned on is not an indication that the Vsw node was pulled up sufficiently High. This Vsw High determination step checks to confirm that it was high enough when the HS switch turned on.

If at 510 it is determined that the Vsw node is High for the sufficient number of cycles, then the routine loops back to 506 and remains in the SS mode with the existing ZCD threshold. On the other hand, if the Vsw was not high at 510, then the routine would proceed to 516 and increase the ZCD threshold to make it harder going forward for SS mode to be entered from determination step 504. This is illustrated in Fig. 6B, which shows a series of timing diagrams illustrating how the routine essentially operates to adjust the threshold based on the inductor current when the regulator is in the SS mode. If it determines that the Vsw is low (not high at 510), it increases the ZCD threshold (Vssth) and causes the regulator to go back into a hard switching mode. This is represented at 652A-652C. Once it is high enough, then the routine maintains the threshold, as shown at 652D, and continues in SS mode.

The ZCD threshold is increased at 516 because the Vsw not going high at 510 indicates that the regulator likely should not have been put into a soft-switch mode. From here, the routine loops back to 502, entering a hard switch mode, and continues as previously described.

Returning back to 508, with the regulator being in SS mode, if the ZCD did not trigger (inductor current not being sufficiently negative to cause Vsw to go above the ZCD threshold), then the routine would proceed to 512 to see if the Vsw went high, as with determination step 510, at some earlier time within the TDP dead period as compared with the assessment time used at 510. If not, the routine loops back to 502 and proceeds as described. However, if Vsw was high at an earlier point in a TDP period, the routine would go to 514 and decrease the ZCD threshold (Vssth). This is because the inductor current was such that the ZCD likely should have switched into the SS mode for a smaller negative inductor current.

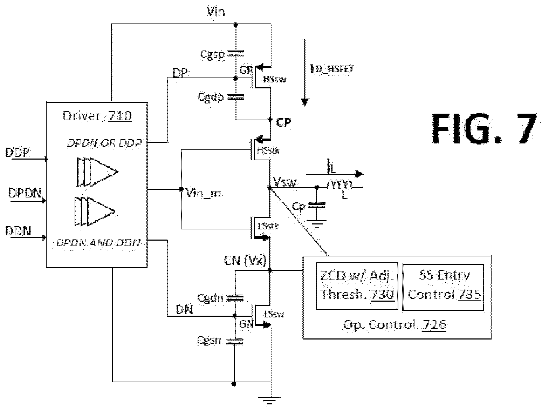

Fig. 7 is a schematic diagram showing a voltage regulator circuit with an adjustable ZCD threshold in accordance with some additional embodiments. In this example, stacked high and low side transistors (HSstk, LSstk) are included with the high and low side switch transistors (HSsw, LSsw) in the HS and LS switches in order to protect the switching transistors from excessive voltage levels. The stack transistors (HSstk, LSstk) are each biased with a fixed voltage (Vin_m) that allows them to track the gate control states of their associated switching transistors. For example, Vin_m may be at a level that is close to Vin/2. They allow HSsw and LSsw transistors to switch as controlled by the gate control voltage (GP, GN) states and at the same time, they share with the switch transistors the overall voltage swing that is imposed onto the power switch stack. The figure also shows the parasitic capacitances (Cgsp, Cgdp, Cgdn, Cgsn) associated with the switching transistors.

In this example, there is a ZCD circuit 730 and a SS entry control circuitry 735 that are part of an operational control circuit block 726, which itself, may be a part of or separate from a PWM circuit, a digital control core, or combinations of the same (dedicated to the regulator or used for multiple regulators). The circuits may be implemented with any suitable circuitry including with one or more finite state machines (FSMs), discrete digital/analog components, firmware running on a controller, or with any combination of the same.

In the depicted embodiment, the ZCD circuit 730 has an input coupled to the inductor switch node (Vsw) to compare it against the adjustable threshold. When, during a low-side on-time phase, the inductor current reverses and is sufficient for Vsw to rise above the ZCD threshold, it asserts, and the information is used by the SS entry control circuit 735 to determine whether or not the regulator should be in a soft or hard switching mode. In addition, the operational control circuitry 735 is coupled to the Vx node to confirm that it went "high" in the TDP dead time to confirm that the inductor current, in fact, was/is sufficiently negative for the HS switch to be controlled to turn On when the Vsw or CP node reaches a sufficient level for zero voltage switching. (Note that the term "zero voltage switching" is a commonly understood concept that does not mean that the FET switches with 0 V across its drain/source, which in most cases is not feasible. Accordingly, it should be appreciated that zero voltage switching refers to switching a transistor when a sufficiently low voltage drop is disposed across its channel terminals, e.g., drain/source. Also, the driver circuit, or whatever circuit is controlling soft-switching, may use a sensed voltage from the CP node, the Vsw node or from any other node indicative of the voltage drop across the transistor being controlled for soft-switching.)

With the depicted implementation, the additional stack transistors may be used in some designs such as with advanced CMOS process nodes where integrated voltage regulators (IVRs) are used. With such processes, transistor device reliability limits can be lower (e.g., ~1.2v) and device thresholds can also be lower than diode cut-in voltages. At the same time, the input voltage (Vin) may be higher than the reliability limits (e.g., Vin up to 2 or more V). In addition, because of the lower threshold voltage levels, the body diodes for the low side transistors may not turn on, with the transistors instead starting to conduct once Vsw is discharged lower than - V_{TH}, causing the drains to act as the sources at this point. Not only is this problematic for the LS transistors, but also, it becomes a reliability risk for the high side transistor drain/source drops, which could be exposed to an even higher voltage drop (Vin + V_{TH}). So, among other things, the added stack transistors serve to protect the switch transistors from being subjected to voltage drops beyond their reliability limits.

In addition, in some embodiments, when the regulator is in a SS mode, and the pulse signal transitions from high to low initiating a pre HS-on (TDP) period, , the driver circuit responds by lowering GN, but not necessarily to 0 V, to keep the LSsw and LSstk transistors barely on. At low-to-intermediate load currents, the inductor current (IL), which typically has reversed in the LS on-time phase, charges the parasitic capacitance of the bridge output (or inductor switch node, Vsw), causing VSW to rise. The duration of the VSW rising transient may be in the range of 200 to 500 pS, depending on the load current. As Vx (CN) rises above half-rail voltage (Vin/2), the low-side switch is turned off. As VSW (and also the voltage at the CP node) rises, e.g., to one P-type FET threshold voltage (V_{ThP}) above Vin/2, the bridge driver for the HS switch turns on the HS FETs, and the switching node (Vsw) approaches Vin. The HS FETs are thus turned on at close to 0V V_{DS}, resulting in soft-switching.

For when higher load currents occur in a soft-switch mode, where the inductor current (I_{L}) does not reverse, the HS switch needs to be turned on even if the inductor switching node (or bridge output) does not rise. This is achieved using a hard switch override circuit (e.g., in the driver circuit), which automatically pulls down the HS switch input (GP) to turn on the HS switches after a time-delay (TDP) when both DP and DDP are high. Thus, the HS driver will force hard-switching on the rising transient if the load current is too high for soft-switching.

During the TDP dead time, there is an I²R loss across the LS FETs because they are barely turned on, providing a relatively high resistance, at least at the front part of the TDP period. At higher loads, this I²R loss adds along with the V*I switching losses of the HS FETs and it is therefore important to keep a lower TDP during hard switching. But, at sufficiently lower loads, I²R losses are less dominant compared to the savings from reduced V*I switching losses across the high switch with soft-switching. Hence a higher TDP may be used for soft-switching to let the reversed inductor current pull up the Vx node and enable the zero-voltage switching for the HS FETs for better efficiency.

There is, therefore, an optimal load point of switching over to soft-switching from hard-switching and vice-versa. This point typically corresponds to where the inductor current is able to reverse and is sufficiently negative to pull up the Vx node within a utilized dead time. However, this point is not the same for all loads. For example, it has been observed that for similar regulators in a processor, optimal points can vary anywhere from 0 to -300 mA. The particular optimal mode changing point will depend on different parameters including inductor values and acceptable TDP dead times, which depend on switching frequencies.

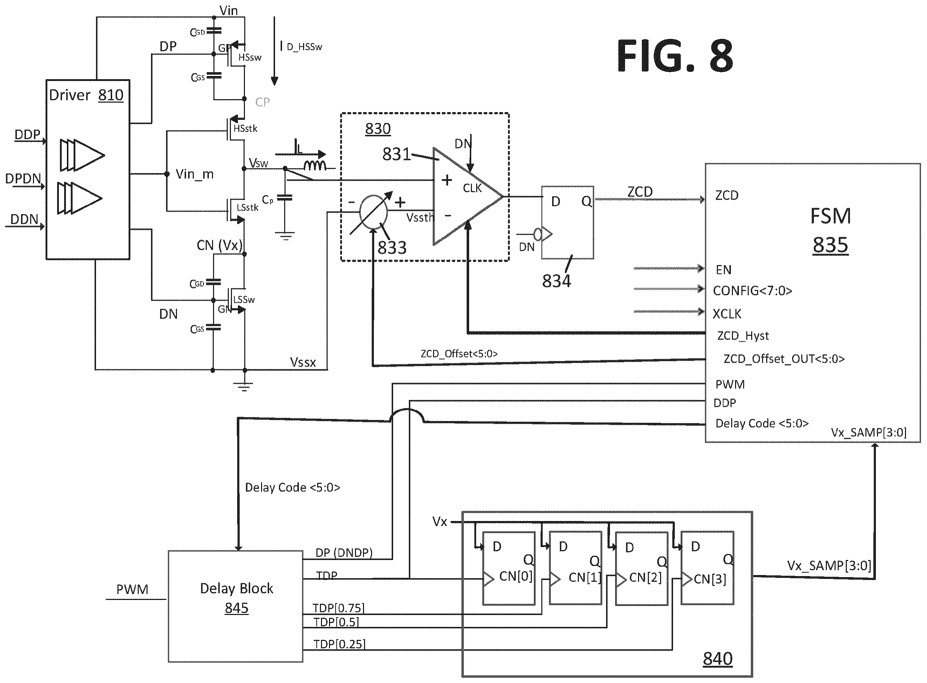

Fig. 8 is a schematic diagram showing an implementation of the circuit of Fig. 7 in accordance with some embodiments. This example includes a ZCD with adjustable threshold circuit 830 and latch 834, along with a soft-switching entry control circuit formed from an FSM circuit 835, SS monitor register 840 and delay block circuit 845 coupled together as shown. The ZCD circuit 835 includes a comparator 831 and a threshold generator 833 to provide an adjustable threshold voltage based on a ZCD Offset code from the FSM. The comparator has a second input that is coupled to the regulator's inductor switch node (Vsw) for comparison against the threshold voltage. The comparator is controlled so that it is active during an LS on-time phase (DN high). The comparator also has a hysteresis function that is enabled/disabled through a ZCD_Hyst signal from the FSM.

The latch (or flop) 834 has an input coupled to the output of the comparator and an output coupled to the FSM at a ZCD input. With this circuit, the latch 834 latches the comparator output to the ZCD input of the FSM when DN (DPDN) goes low, i.e., at the end of an LS on-time phase and at the beginning of a TDP dead time period.

The delay block circuit 845 receives a PWM clock, e.g., used to generate the DPDN pulse train signal. It also receives a delay code from the FSM to control the DDP and DDN delay times, and it provides a TDP signal, which corresponds to the DDP signal, and generates from it fractional TDP delay signals: TDP[0.75, TDP[0.5], and TDP[0.25], providing 25%, 50% and 75% delay versions, respectively, of the TDP signal.

The SS monitor register 840 acts as a SS evaluation circuit, which may be any suitable circuit used to evaluate a node in the power stack to assess whether Vsw rose sufficiently for the HS switch to be soft-switched. The SS monitor register includes latches (or flops), CN[0] through CN[3]. They each have data inputs that are coupled to the Vx node. Since the VSW may be a relatively high swing signal (swings between Vssx to Vin), the Vx (or CN) node is used instead. Its high swing is limited to Vin_m due to the stack biasing. In this way, the Vx node (and indirectly the Vsw node) can be sampled using standard cell digital sequential circuits such as the CN latches in this embodiment. When Vx rises above ~Vin_m/2 (switching threshold of digital cells), the latches will evaluate Vx as a high and if it does not rise to this level, it will evaluate as a low value.

The CN latches have clock inputs that are coupled, respectively, to separate instances of the TDP fractional signals as indicated. The TDP signal, itself, latches Vx into CN[0] at the end of the TDP period, while TDP[0.75] latches Vx into CN[1] at 75% of the TDP period, TDP[0. 5] latches Vx into CN[2] at 50% of the TDP period, and TDP[0.25] latches Vx into CN[3] at 25% of the TDP period. In this way, the latches function as a 4-bit register to sample the Vx node (high or low) at 25% interval points across the TDP dead time periods. With this example, the CN[0] sample (end of TDP) is used for assessing if the Vx, and thus the Vsw, nodes are sufficiently rising for efficient SS operation. However, depending on specific design implementations, any of or a combination of the samples could alternatively be used. A purpose of using multiple point sampling is that it gives additional load current information to the FSM for a more complete picture, allowing it to better control the SS entry threshold (Vssth). Also, it can provide a post silicon hook to change sampling edges for debug and/or optimization.

When in operation, the ZCD comparator 831 compares Vsw with the ZCD threshold voltage, as set by threshold generator 833, at the end of the LS FET on-time phases. With sufficiently negative inductor currents, Vsw will be larger than Vssth while for less negative or positive currents, Vsw will be less than Vssth. The output of the comparator is therefore high when the inductor valley current is negative. A latched version (834) of this output is sampled by the FSM for a programmable consecutive cycle count to decide entry into soft-switching.

After deciding the soft-switching entry, the FSM sends a signal (ZCD_Hyst) to the ZCD comparator to add a fixed hysteresis offset to avoid comparator output glitching while the TDP delay is slowly increased for the change to soft-switch mode. (Dynamic changes in the TDP dead-time can change the effective regulator duty-cycle as it reduces the HS on pulse width, which may be compensated by a regulator control loop, momentarily increasing the inductor current, which could lead to glitching at the comparator output in the absence of hysteresis.) After the TDP delay is increased (e.g., one code increment at a time over a number of programmable cycles) to a longer TDP delay used for SS mode, the hysteresis is then removed. From here, the FSM samples the Vx node, e.g., at the end of the TDP period (CN[0]) to monitor the Vx node to determine if Vx is consistently sufficiently rising (sampling high), indicating that the soft-switching state is warranted.

If it is observed that the switching node did not charge enough over multiple Vx samples, it can be inferred that the inductor current is not going sufficiently negative and soft-switching entry has been prematurely entered. In response, the soft-switching entry threshold (Vssth) is updated (increased) and an exit from soft-switching is performed. This process continues until the threshold reaches a suitable point where soft-switching is enabled with sufficiently negative inductor current such that VSW charges high enough within a TDP period to improve efficiency.

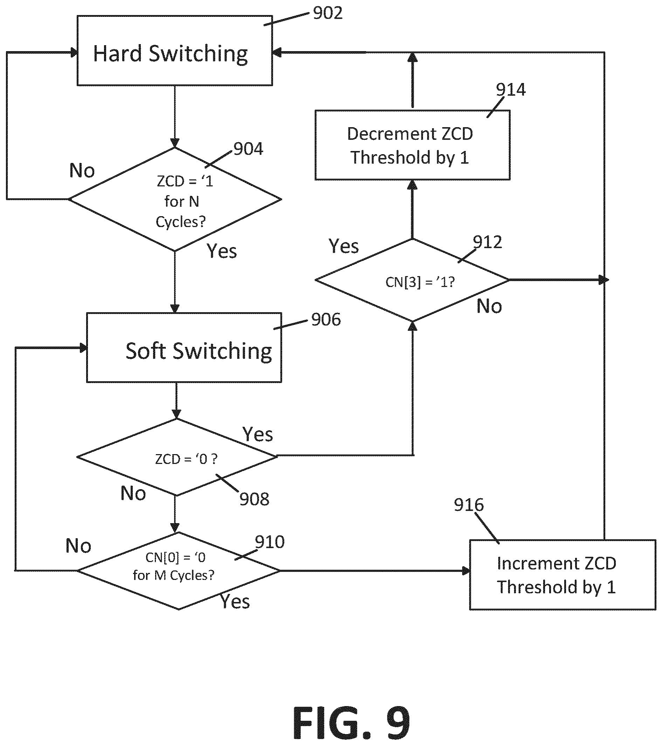

Fig. 9 is a flow diagram showing a routine for managing soft-switching entry in accordance with some embodiments of the regulator of Fig. 8. At 902, the regulator is in a hard switch mode. At 904, it checks to see if the ZCD output is high for N consecutive cycles. If not, the regulator remains in hard switch mode, but if the latched ZCD output is high for enough cycles, then the routine goes to 906 and enters into a Soft-switch mode.

At 908, it determines if the latched ZCD output is low. If not, then it goes to 910 and checks to see if the CN[0] output is low for M cycles (indicating SS mode is warranted), the routine loops back to 906 and remains in SS mode. Otherwise, if CN[0] is low for M consecutive cycles (indicating Vx is not being consistently pulled up and SS mode is not warranted), then at 916, the SS entry threshold (Vssth) is increased by 1 bit making the inductor current threshold more negative. From here, the routine loops back to 902 and enters back into a hard switch mode. In some embodiments, the soft-switch mode is exited by asserting ZCD hysteresis at comparator 831 and the TDP value is reduced to a lower hard switch mode value over multiple cycles. Once the TDP delay reaches the desired HS mode value, the ZCD hysteresis is disabled and new entry into soft-switching is based on the updated ZCD comparator threshold.

Returning back to 908, if the ZCD output was low, then the routine would proceed to 912 and check to see if CN[3] was high. If the CN[3] output was high during the beginning of the TDP period, it may indicate the possibility that Vx was pulled up by a sufficient reverse inductor current despite the ZCD output being low and thus, the ZCD threshold is too high (inductor current threshold too negative). If this is the case, then at 914, the ZCD threshold (Vssth) is decreased to make the inductor current threshold less negative, and the routine returns to 902, exiting from soft-switching. If at 912, the CN[3] value was not high, then the routine would go directly to 902.

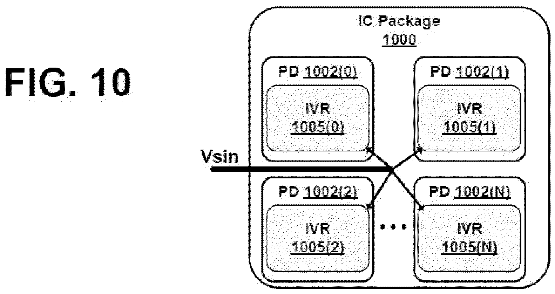

Fig. 10 is a schematic diagram showing an integrated circuit (IC) package 1000 in accordance with some embodiments. This is a simplified view illustrating how multiple IVRs (integrated voltage regulators) 1005 such as any of the previously described regulator circuit embodiments may be used in an IC package to provide power to different power domains 902 within the package. The regulators 1005 receive an input supply (Vsin), which may or may not be from off the package. Each IVR provides a regulated supply voltage to its associated power domain from this input supply. More aggressive power management has led to the creation of finer, smaller power domains and with the wide dynamic load ranges that are attributed to many domains, IVRs with very good light-load efficiencies are valued more than ever. The regulator embodiments disclosed herein are well suited for IVR implementation where multiple, if not many, switching regulators may be disposed in a single IC die and/or package.

The IC package 1000 may include a plurality of different chips (or dies) including compute dies, graphics processing dies, artificial intelligence (AI) processing dies, memory dies, input/output (IO) dies, and/or any combination of the same. The dies may be mounted in 2.5D and/or 3D stacks with one or more base substrates, interposers and/or bridges to couple at least some of the dies to one another. Also, in some embodiments, the regulators have capacitors and inductors that may be disposed in the dies, within the package outside of the dies or even outside of the package. That is, integrated voltage regulators, as used herein, refers to regulator circuitry such as control circuits and inductor high side and low side switches being formed on circuits in at least some of the dies they serve, but not all of the regulator components need be part of the chips, or dies, themselves.

### System

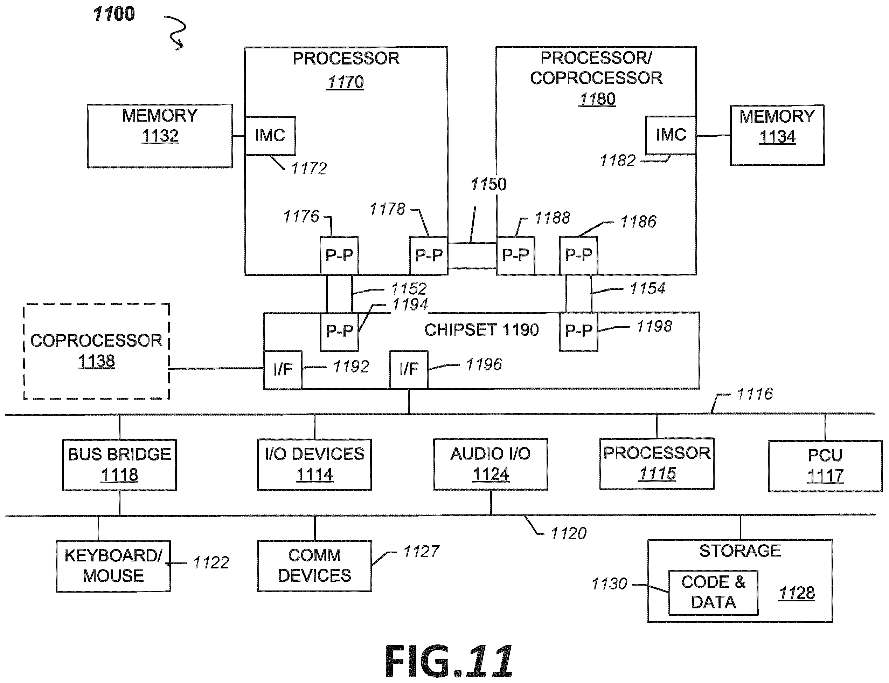

Fig. 11 illustrates an example computing system in accordance with some embodiments. Multiprocessor system 1100 is an interfaced system and includes a plurality of processors including a first processor 1170 and a second processor 1180 coupled via an interface 1150 such as a point-to-point (P-P) interconnect, a fabric, and/or bus. In some examples, the first processor 1170 and the second processor 1180 are homogeneous. In some examples, first processor 1170 and the second processor 1180 are heterogenous. Though the example system 1100 is shown to have two processors, the system may have three or more processors, or may be a single processor system. In some examples, the computing system is implemented, wholly or partially, with a system on a chip (SoC) or a multi-chip (or multi-chiplet) module, in the same or in different package combinations.

Processors 1170 and 1180 are shown including integrated memory controller (IMC) circuitry 1172 and 1182, respectively. Processor 1170 also includes interface circuits 1176 and 1178, along with core sets. Similarly, second processor 1180 includes interface circuits 1186 and 1188, along with a core set as well. A core set generally refers to one or more compute cores that may or may not be grouped into different clusters, hierarchal groups, or groups of common core types. Cores may be configured differently for performing different functions and/or instructions at different performance and/or power levels. The processors may also include other blocks such as memory and other processing unit engines.

Processors 1170, 1180 may exchange information via the interface 1150 using interface circuits 1178, 1188. IMCs 1172 and 1182 couple the processors 1170, 1180 to respective memories, namely a memory 1132 and a memory 1134, which may be portions of main memory locally attached to the respective processors.

Processors 1170, 1180 may each exchange information with a network interface (NW I/F) 1190 via individual interfaces 1152, 1154 using interface circuits 1176, 1194, 1186, 1198. The network interface 1190 (e.g., one or more of an interconnect, bus, and/or fabric, and in some examples is a chipset) may optionally exchange information with a coprocessor 1138 via an interface circuit 1192. In some examples, the coprocessor 1138 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 1170, 1180 or outside of both processors, yet connected with the processors via an interface such as P-P interconnect, such that either or both processors' local cache information may be stored in the shared cache if a processor is placed into a low power mode.

Network interface 1190 may be coupled to a first interface 1116 via interface circuit 1196. In some examples, first interface 1116 may be an interface such as a Peripheral Component Interconnect (PCI) interconnect, a PCI Express interconnect, or another I/O interconnect. In some examples, first interface 1116 is coupled to a power control unit (PCU) 1117, which may include circuitry, software, and/or firmware to perform power management operations with regard to the processors 1170, 1180 and/or co-processor 1138. PCU 1117 provides control information to one or more voltage regulators (which may be implemented with any of the voltage regulator circuits described herein) to cause the voltage regulator(s) to generate the appropriate regulated voltage(s). PCU 1117 also provides control information to control the operating voltage generated. In various examples, PCU 1117 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 1117 is illustrated as being present as logic separate from the processor 1170 and/or processor 1180. In other cases, PCU 1117 may execute on a given one or more of cores (not shown) of processor 1170 or 1180. In some cases, PCU 1117 may be implemented as a microcontroller (dedicated or general-purpose) or other control logic configured to execute its own dedicated power management code, sometimes referred to as P-code. In yet other examples, power management operations to be performed by PCU 1117 may be implemented externally to a processor, such as by way of a separate power management integrated circuit (PMIC) or another component external to the processor. In yet other examples, power management operations to be performed by PCU 1117 may be implemented within BIOS or other system software. Along these lines, power management may be performed in concert with other power control units implemented autonomously or semi-autonomously, e.g., as controllers or executing software in cores, clusters, IP blocks and/or in other parts of the overall system.

Various I/O devices 1114 may be coupled to first interface 1116, along with a bus bridge 1118 which couples first interface 1116 to a second interface 1120. In some examples, one or more additional processor(s) 1115, such as coprocessors, high throughput many integrated core (MIC) processors, GPGPUs, accelerators (such as graphics accelerators or digital signal processing (DSP) units), field programmable gate arrays (FPGAs), or any other processor, are coupled to first interface 1116. In some examples, second interface 1120 may be a low pin count (LPC) interface. Various devices may be coupled to second interface 1120 including, for example, a keyboard and/or mouse 1122, communication devices 1127 and storage circuitry 1128. Storage circuitry 1128 may be one or more non-transitory machine-readable storage media as described below, such as a disk drive or other mass storage device which may include instructions/code and data 1130 and may implement the storage in some examples. Further, an audio I/O 1124 may be coupled to second interface 1120. Note that other architectures than the point-to-point architecture described above are possible. For example, instead of the point-to-point architecture, a system such as multiprocessor system 1100 may implement a multi-drop interface or other such architecture.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may be included on the same die as the described CPU (sometimes referred to as the application core(s) or application processor(s)), the above described coprocessor, and additional functionality. Example core architectures are described next, followed by descriptions of example processors and computer architectures.

### Example Embodiments

Illustrative examples of the technologies disclosed herein are provided below. An embodiment of the technologies may include any one or more, and any compatible combination of, the examples described below.

Example 1 is an apparatus that includes an inductor switching (Vsw) node, a zero crossing detection (ZCD) circuit, and a SS entry control circuit. The ZCD circuit has an adjustable threshold, and it also includes a ZCD input coupled to the Vsw node, a ZCD output, and a ZCD threshold control node. The soft-switch (SS) entry control circuit is coupled to the ZCD output and to the ZCD threshold control node.

Example 2 includes the subject matter of example 1, and wherein the Z CD threshold is at a level for the ZCD circuit to detect when an inductor current flowing into the Vsw node is sufficiently negative to surpass a negative current threshold that corresponds to the ZCD threshold, wherein increasing the ZCD threshold increases an amount of negative current required to surpass the negative current threshold.

Example 3 includes the subject matter of any of examples 1-2, and wherein the SS entry control circuit is to cause a switching regulator to enter into a soft-switch mode in response to the ZCD circuit detecting the inductor current being sufficiently negative.

Example 4 includes the subject matter of any of examples 1-3, and comprising a SS evaluation circuit to detect if the Vsw node voltage sufficiently rose in a TDP dead time period between a low-side to a high side switch transition.

Example 5 includes the subject matter of any of examples 1-4, and wherein the SS evaluation detection circuit has an input coupled to the Vsw node.

Example 6 includes the subject matter of any of examples 1-5, and wherein the SS evaluation detection circuit input is coupled to the Vsw node through a different node that is part of a low side switch.

Example 7 includes the subject matter of any of examples 1-6, and wherein the SS evaluation detection circuit includes a sequential circuit with a clock input that is coupled to a delay signal node for controlling the TDP dead time period.

Example 8 includes the subject matter of any of examples 1-7, and wherein the adjustable ZCD circuit includes a comparator with a hysteresis control node.

Example 9 includes the subject matter of any of examples 1-8, and wherein the SS entry control circuit is to cause the switching regulator to exit from the soft-switch mode in response to the ZCD circuit detecting the inductor current not being sufficiently negative.

Example 10 includes the subject matter of any of examples 1-9, and wherein the switching regulator is to exit from the soft-switch mode in response to the ZCD circuit detecting the inductor current not being sufficiently negative for a predefined number of switching cycles.

Example 11 includes the subject matter of any of examples 1-10, and wherein the SS entry control circuit is to increase the ZCD threshold if it exits from the soft-switch mode.

Example 12 includes the subject matter of any of examples 1-11, and comprising a switching buck type regulator including the ZCD and SS entry control circuits.

Example 13 is a voltage regulator apparatus that includes high and low side switches and a first comparator. The high side (HS) switch is coupled to the low side (LS) switch through an inductor switching node (Vsw). The first comparator is coupled to the Vsw node to compare an inductor current at the Vsw node with an adjustable negative inductor current threshold.

Example 14 includes the subject matter of example 13, and wherein the first comparator is to compare the inductor current with the adjustable negative inductor current threshold when the LS switch transitions from an LS on-time phase to a dead time period that precedes an HS on-time phase.

Example 15 includes the subject matter of any of examples 13-14, and comprising a first latch coupled to an output of the first comparator to latch a comparison output value in response to the transition from the LS on-time phase.

Example 16 includes the subject matter of any of examples 13-15, and including a SS entry control circuit coupled to the latch to cause the voltage regulator to enter into a soft-switch mode if the comparison output value indicates the inductor current at the Vsw node to be more negative than the adjustable negative inductor current threshold.

Example 17 includes the subject matter of any of examples 13-16, and wherein the low side switch includes a low side (LS) switch transistor and an LS stack transistor coupled together at a common (CN) node.

Example 18 includes the subject matter of any of examples 13-17, and comprising a SS evaluation circuit coupled to the CN node to determine if a voltage at the Vsw node rose sufficiently for soft-switching of the HS switch.

Example 19 includes the subject matter of any of examples 13-18, and wherein the SS evaluation circuit is to evaluate the CN node in a TDP dead time period, wherein the TDP dead time period occurs between the LS switch transitioning to an Off phase and the HS switch transitioning to an On phase.

Example 20 includes the subject matter of any of examples 13-20, and wherein the SS evaluation circuit is to evaluate the CN node in response to the HS switch transitioning to the On phase.

Example 21 is an apparatus that includes a processor and a plurality of switching voltage regulators. The processor includes a plurality of power domains. The plurality of switching voltage regulators provide regulated voltage supplies to the plurality of power domains. At least some of the voltage regulators include high and low side switches, a zero cross detection circuit, and a SS entry control circuit. The high side (HS) switch is coupled to the low side (LS) switch through an inductor switching node (Vsw). The zero cross detection (ZCD) circuit has an adjustable threshold, and the ZCD circuit has a ZCD input coupled to the Vsw node, a ZCD output, and a ZCD threshold control node. The soft-switch (SS) entry control circuit is coupled to the ZCD output and to the ZCD threshold control node.

Example 22 includes the subject matter of example 21, and wherein the Z CD threshold is at a level for the ZCD circuit to detect when an inductor current flowing into the Vsw node is sufficiently negative to surpass a negative current threshold that corresponds to the ZCD threshold, wherein increasing the ZCD threshold increases an amount of negative current required to surpass the negative current threshold.

Example 23 includes the subject matter of any of examples 21-22, and wherein the SS entry control circuit is to cause a switching regulator to enter into a soft-switch mode in response to the ZCD circuit detecting the inductor current being sufficiently negative.

Example 24 includes the subject matter of any of examples 21-23, and comprising a SS evaluation circuit to detect if the Vsw node voltage sufficiently rose in a TDP dead time period between a low-side to a high side switch transition.

Example 25 includes the subject matter of any of examples 21-24, and wherein the SS evaluation detection circuit has an input coupled to the Vsw node.

Example 26 includes the subject matter of any of examples 21-25, and wherein the SS evaluation detection circuit input is coupled to the Vsw node through a different node that is part of a low side switch.

Example 27 includes the subject matter of any of examples 21-26, and wherein the SS evaluation detection circuit includes a sequential circuit with a clock input that is coupled to a delay signal node for controlling the TDP dead time period.

Example 28 includes the subject matter of any of examples 21-27, and wherein the adjustable ZCD circuit includes a comparator with a hysteresis control node.

Example 29 includes the subject matter of any of examples 21-28, and wherein the SS entry control circuit is to cause the switching regulator to exit from the soft-switch mode in response to the ZCD circuit detecting the inductor current not being sufficiently negative.

Example 30 includes the subject matter of any of examples 21-29, and wherein the switching regulator is to exit from the soft-switch mode in response to the ZCD circuit detecting the inductor current not being sufficiently negative for a predefined number of switching cycles.

Example 31 includes the subject matter of any of examples 21-30, and wherein the SS entry control circuit is to increase the ZCD threshold if it exits from the soft-switch mode.

### Definitions

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "circuit" or "module" may refer to one or more passive and/or active components that are arranged to cooperate with one another to provide a desired function. It should be appreciated that different circuits or modules may consist of separate components, they may include both distinct and shared components, or they may consist of the same components. For example, A controller circuit may be a first circuit for performing a first function, and at the same time, it may be a second controller circuit for performing a second function, related or not related to the first function.

The meaning of "in" includes "in" and "on" unless expressly distinguished for a specific description.

The terms "substantially," "close," "approximately," "near," and "about," unless otherwise indicated, generally refer to being within +/-10% of a target value.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

For purposes of the embodiments, unless expressly described differently, the transistors in various circuits and logic blocks described herein may be implemented with any suitable transistor type such as field effect transistors (FETs) or bipolar type transistors. FET transistor types may include but are not limited to metal oxide semiconductor (MOS) type FETs such as tri-gate, FinFET, and gate all around (GAA) FET transistors, as well as tunneling FET (TFET) transistors, ferroelectric FET (FeFET) transistors, or other transistor device types such as carbon nanotubes or spintronic devices.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are dependent Note that in the corresponding drawings of the embodiments, signals are represented with lines. Some lines may be thicker, to indicate a greater number of constituent signal paths, and/or have arrows at one or more ends, to indicate a direction of information flow. Such indications are not intended to be limiting. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme upon the platform within which the present disclosure is to be implemented.

As defined herein, the term "computer readable storage medium" means a storage medium that contains or stores program code for use by or in connection with an instruction execution system, apparatus, or device. As defined herein, a "computer readable storage medium" is not a transitory, propagating signal per se. A computer readable storage medium may be, but is not limited to, an electronic storage device, a magnetic storage device, an optical storage device, an electromagnetic storage device, a semiconductor storage device, or any suitable combination of the foregoing. Memory elements, as described herein, are examples of a computer readable storage medium.

As defined herein, the term "if" means "when" or "upon" or "in response to" or "responsive to," depending upon the context. Thus, the phrase "if it is determined" or "if [a stated condition or event] is detected" may be construed to mean "upon determining" or "in response to determining" or "upon detecting [the stated condition or event]" or "in response to detecting [the stated condition or event]" or "responsive to detecting [the stated condition or event]" depending on the context. As defined herein, the term "responsive to" means responding or reacting readily to an action or event. Thus, if a second action is performed "responsive to" a first action, there is a causal relationship between an occurrence of the first action and an occurrence of the second action. The term "responsive to" indicates the causal relationship.

As defined herein, the term "processor" means at least one hardware circuit configured to carry out instructions contained in program code. The hardware circuit may be implemented with one or more integrated circuits. Examples of a processor include, but are not limited to, a central processing unit (CPU), an array processor, a vector processor, a digital signal processor (DSP), a field-programmable gate array (FPGA), a programmable logic array (PLA), an application specific integrated circuit (ASIC), programmable logic circuitry, a graphics processing unit (GPU), a controller, and so forth. It should be appreciated that a logical processor, on the other hand, is a processing abstraction associated with a core, for example when one or more SMT cores are being used such that multiple logical processors may be associated with a given core, for example, in the context of core thread assignment.

It should be appreciated that a processor or processor system may be implemented in various different manners. For example, it may be implemented on a single die, multiple dies (dielets, chiplets), one or more dies in a common package, or one or more dies in multiple packages. Along these lines, some of these blocks may be located separately on different dies or together on two or more different dies.

### Alternative Embodiments

While the flow diagrams in the figures show a particular order of operations performed by certain embodiments of the invention, it should be understood that such order is exemplary (e.g., alternative embodiments may perform the operations in a different order, combine certain operations, overlap certain operations, etc.).

While the invention has been described in terms of several embodiments, those skilled in the art will recognize that the invention is not limited to the embodiments described, can be practiced with modification and alteration within the spirit and scope of the appended claims. The description is thus to be regarded as illustrative instead of limiting.

## Claims

1. An apparatus, comprising:
an inductor switching (Vsw) node;
a zero cross detection (ZCD) circuit with an adjustable threshold, the ZCD circuit having a ZCD input coupled to the Vsw node, a ZCD output, and a ZCD threshold control node; and
a soft switch (SS) entry control circuit coupled to the ZCD output and to the ZCD threshold control node.

2. The apparatus of claim 1,
wherein the Z CD threshold is at a level for the ZCD circuit to detect when an inductor current flowing into the Vsw node is sufficiently negative to surpass a negative current threshold that corresponds to the ZCD threshold, wherein increasing the ZCD threshold increases an amount of negative current required to surpass the negative current threshold.

3. The apparatus of claim 2,
wherein the SS entry control circuit is to cause a switching regulator to enter into a soft switch mode in response to the ZCD circuit detecting the inductor current being sufficiently negative.

4. The apparatus of claim 3, comprising
an SS evaluation circuit to detect if the Vsw node voltage sufficiently rose in a TDP dead time period between a low-side to a high side switch transition.

5. The apparatus of claim 4,
wherein the SS evaluation detection circuit has an input coupled to the Vsw node.

6. The apparatus of claim 5,
wherein the SS evaluation detection circuit input is coupled to the Vsw node through a different node that is part of a low side switch.

7. The apparatus of claim 6,
wherein the SS evaluation detection circuit includes a sequential circuit with a clock input that is coupled to a delay signal node for controlling the TDP dead time period.

8. The apparatus of any of claims 1-7,
wherein the adjustable ZCD circuit includes a comparator with a hysteresis control node.

9. The apparatus of any of claims 3-8,
wherein the SS entry control circuit is to cause the switching regulator to exit from the soft switch mode in response to the ZCD circuit detecting the inductor current not being sufficiently negative.

10. The apparatus of claim 9,
wherein the switching regulator is to exit from the soft switch mode in response to the ZCD circuit detecting the inductor current not being sufficiently negative for a predefined number of switching cycles.

11. The apparatus of claim 9,
wherein the SS entry control circuit is to increase the ZCD threshold if it exits from the soft switch mode.

12. The apparatus of any of claims 9-11, comprising
a switching buck type regulator including the ZCD and SS entry control circuits.

13. A processor apparatus comprising one or more switching type buck regulators in accordance with the apparatus of claim 12.

14. A compute platform comprising a processor apparatus in accordance with claim 13.
